# EUROPEAN PATENT APPLICATION

(11) **EP 2 053 652 A1**
(43) Date of publication of application: **29.04.2009**
(21) Application number: 07301118.1
(22) Date of filing: 15.06.2007
(51) Int. Cl.: H01L 21/8234, H01L 21/8238

(54) **Process for manufacturing field effect transistors**

(71) Applicant: STMICROELECTRONICS SA, 92120 Montrouge (FR); STMicroeletronics Crolles 2 SAS, 38920 Crolles (FR)
(72) Inventor: Coronel, Philippe, 38530 Barraux (FR); Rivoire, Maurice, 38240 Meylan (FR); Cosnier, Vincent, 38000 Grenoble (FR); Aime, Delphine, 38000 Grenoble (FR)
(74) Representative: Cabinet Plasseraud

(57) **Abstract**

A process for manufacturing field effect transistors on a substrate (100) for integrated circuit comprises depositing a first gate stack (10) on the substrate in first (Z1) and second (Z2) active zones. The first gate stack is removed in the second active zone (Z2). A second gate stack (20) is deposited on the circuit and then removed in the first active zone (Z1) using a chemical-mechanical polishing process. Each one of the first and second gate stacks (10, 20) comprises a dielectric layer (11, 21) and a metal-like layer (12, 22), thereby enabling the materials of the gate electrode and the gate insulating layer for a first transistor be selected independently of the materials for a second transistor. The process is appropriate for manufacturing C-MOS integrated circuits.

## Description

The invention relates to a process for manufacturing field effect transistors with varying gate stacks.

C-MOS ("Complementary Metal-Oxide-Semiconductor") integrated circuits are of common use, in particular for circuits designed for performing digital functions. Such C-MOS circuit comprises both p-MOS field effect transistors and n-MOS field effect transistors arranged at the surface of a substrate of the circuit. In a known manner p-MOS and n-MOS transistors have respective gate electrodes which differ from each other. When these gate electrodes are silicon-based, mainly polysilicon-based, those of p-MOS and n-MOS transistors are p-doped and n-doped, respectively.

It is known using metal-like materials, i.e. material with metal-like electrical conductivity, for producing the gate electrode of a MOS transistor, instead of using a semiconducting material. This avoids the band edge bending effect that occurs at the interface between a semiconducting gate electrode and the gate insulating layer of a MOS transistor. As a consequence, the capacitance effective thickness of the gate insulating layer for a transistor MOS with a metal-like gate electrode is less than that of a similar transistor with the gate electrode composed of semiconducting material. Then, the actual thickness of the gate insulating layer can be increased in case of a metal-like gate electrode, for reducing the leakage current that may flow from the gate electrode to the transistor channel, through the gate insulating layer.

It is also known to vary the metal-like material of the gate electrodes in a C-MOS circuit, depending on the p-MOS type or n-MOS type of each transistor. For example, tantalum carbide (TaC), tantalum nitride (TaN), tantalum silicide (TaSi₂) and titanium silicide (TiSi₂) are of common use for gate electrodes of n-MOS transistors, whereas molybdenum (Mo), tungsten nitride (WN) and ruthenium (Ru) are used for gate electrodes of p-MOS transistors. Therefore, one has to form on the circuit gate electrode portions of two different metal-like materials for manufacturing a C-MOS integrated circuit.

US 7,074,664 discloses a process for manufacturing a C-MOS circuit with varying metal-like gate material. According to this process, the surface of a C-MOS circuit substrate is first coated with a gate insulating layer, in active zones of the substrate that are dedicated for p-MOS transistors and n-MOS transistors. Then, a layer of a first metal-like material is deposited on the gate insulating layer over the whole surface, and selectively removed in the active zones dedicated to the transistors of one and same type. Afterwards, a layer of a second metal-like material is deposited over the circuit, on the first metal-like layer where parts of that layer remain and on the gate insulating layer where the first metal-like layer has been removed. Finally, the upper surface of the circuit is made planar by chemical-mechanical polishing (CMP), until parts of the second metal-like layer that are superposed on top of parts of the first metal-like layer are removed. The circuit being manufactured in this way has varying metal-like material portions in the active zones which are respectively dedicated to MOS transistors of either p-MOS or n-MOS type. Transistor gate electrodes are then completed from all metal-like material portions.

But such process has the following drawbacks:
- the surface of the gate insulating layer is exposed when the first metal-like layer is removed, in the active zones corresponding to the transistors with gate electrodes composed of the second metal-like material. Then, the gate insulating layer in these actives zones may be altered, polluted or damaged during the first metal-like layer removal or at the beginning of the deposition of the second metal-like layer. This causes the threshold voltage of the transistors with gate electrodes composed of the second metal-like material be poorly controlled;
- the surface of the first metal-like layer is exposed when superposed parts of the second metal-like layer are removed. Then, the first metal-like layer may also be altered, oxidized, scratched or damaged otherwise, which may result in poorly controlled threshold voltage of the transistors with gate electrodes composed of this material; and
- all p-MOS or n-MOS transistors of the C-MOS circuit has a same gate insulating layer.

Article "Highly Manufacturable 45 nm LSTP CMOSFETs Using Novel Dual High-k and Dual Metal CMOS Integration" (S.C. Song et al., SEMATEC, IEEE, 2006 Symposium on VLSI Technology Digest of Technical Papers) discloses another C-MOS circuit manufacturing process which combines varying dielectric materials for the gate insulating layers and varying metal-like materials for the gate electrodes, depending on the p-MOS or n-MOS type of each transistor of the circuit. According to this another C-MOS process, a first gate stack is first deposited on the circuit substrate, which first gate stack comprises a first dielectric layer and a first metal-like layer. This first gate stack is covered with first hard mask portions in first active zones dedicated to a first type of the transistors, and uncovered parts of the first gate stack are then removed. A second gate stack comprising a second dielectric layer and a second metal-like layer is deposited over the circuit, on the first hard mask portions in the first active zones and on the substrate surface in second active zones separated from the first active zones. Then, second hard mask portions are formed in the second active zones, on the second gate stack, with substantially same thickness as the first hard mask portions in the first active zones. Parts of the second gate stack which are between the first and second active zones, for example above substrate insulating barriers such as STIs ("Shallow Trench Isolator"), are then removed. This other process results in having differing dielectric materials for the gate insulating layers as well as differing metal-like materials for the gate electrodes in the first and second active zones. It is therefore possible to adapt the dielectric material depending on the p-MOS or n-MOS type of the transistors in the respective active zones.

But this other process has the following drawbacks:
- numerous process steps are necessary, which increase the production cycle and reduce the production yield;
- the second hard mask portions are defined via a special lithography mask, which has to be complementary with respect to the first hard mask portions, and must be aligned critically with these latter, and
- unless polysilicon-based material is used for first and second hard mask portions, these hard masks portions have to be removed before the gate structures of all transistors are completed.

An object of the present invention is to provide a novel process for manufacturing an integrated circuit with two types of field effect transistors, which process does not have the drawbacks of the known processes here-above indicated.

To this end, the invention proposes a process for manufacturing a first field effect transistor and a second field effect transistor on a substrate of an integrated circuit, which process comprises the following steps:
/1/ depositing a first gate stack on a surface of the substrate, in first and second active zones respectively of first and second transistors, the first gate stack comprising a first dielectric layer and a first metal-like layer deposited after the first dielectric layer;
/2/ removing the first gate stack selectively in the second active zone;
/3/ depositing a second gate stack above the first gate stack in the first active zone and on the surface of the substrate in the second active zone, the second gate stack comprising at least a second metal-like layer; and
/4/ removing the second gate stack in the first active zone by performing a chemical-mechanical polishing for removal of at least the second metal-like layer.

According to the invention, the second gate stack further comprises a second dielectric layer which is deposited before the second metal-like layer. Thus, a CMOS integrated circuit manufactured by using such process may have varying dielectric materials for the gate insulating layers of the transistors and varying metal-like materials for the gate electrodes in the first and second active zones. First and second dielectric layers may be composed of same or different respective dielectric materials. In particular, at least one of the first and second dielectric layers may comprise a dielectric material with permittivity higher than 10, preferably higher than 25. High permittivity dielectric materials are hafnium oxide (HfO₂), titanium oxide (TiO₂), alumina (Al₂O₃), silicon oxynitride (SiON), etc. Thus, transistors with reduced capacitance effective thicknesses of the gate insulating layers can be produced, although the actual thicknesses of the gate insulating layers are large enough for obtaining low gate to channel leakage current.

Advantageously, the materials of first and second dielectric layers together with the materials of first and second metal-like layers can be adapted depending on the types of the first and second field effect transistors. For example, first and second transistors may be of opposite types selected from p-MOS and n-MOS types when the circuit is of C-MOS type. In such case, first and second metal-like layers may be of different respective materials. These materials can be selected based on work function values for obtaining desired threshold voltage values. According to another example, first and second transistors may be adapted for different respective operations selected from analog operation and digital operation.

A first advantage of a process according to the invention is that a single added lithography step is required. This lithography step is used in step /2/ for removing the first gate stack selectively in the second active zone. Moreover, a lithography mask already used beforehand for doping the substrate in the second active zone may be used again in step /2/.

A second advantage results from the fact that the second dielectric layer is not exposed again in the second active zone after it has been deposited in step /3/. This avoids that the dielectric layer of the second field effect transistor be altered, polluted or damaged. The threshold voltage of the second transistor can be thus well-controlled. In particular, it can be set in a reproducible and accurate manner.

A third advantage is that the overall step number of the process is limited. Then, production cycle of the circuit is not substantially increased compared to the C-MOS manufacturing processes used before the invention.

A fourth advantage is that every step of the process involves well-controlled circuit processing methods and tools, so that a production yield is substantially unchanged.

According to an improvement of the invention, each one of the first and second gate stacks may further comprise respectively first and second silicon-based layers which are deposited after the first or second metal-like layer in the corresponding first gate stack or second gate stack. Such silicon-based layers added in the gate stacks may form upper parts of the final gate electrodes of the transistors. They avoid that the first and second metal-like layers be exposed again after being deposited. Thus, first and second metal-like layers are not altered, polluted or oxidized, so that nominal work function values of the metal-like materials used are maintained.

Other explanations and advantages of the invention will be apparent from the detailed non-limiting implementation examples described hereafter, in connection with the appended drawings comprising:
- Figure 1-8 are cross-sectional views of an integrated electronic circuit being manufactured, corresponding to successive steps of a process according to the invention; and
- Figures 9a and 9b illustrate a first alternative implementation; and
- Figures 10a and10b illustrate a second alternative implementation.

For the sake of clarity, dimensions of circuit parts that are represented on these figures are not in relation with actual dimensions or actual dimension ratios. In addition, identical reference numbers indicated on different figures refer to identical elements. The circuit is located in the bottom parts of the figures, with active surface facing upwards. N indicates a vertical direction oriented from bottom to top of the figures. Words "on", "above", "below", "lower" and "upper" are used hereafter in reference with direction N.

An implementation of the invention is described now, in which circuit processing steps are cited in a correct order so as to reproduce the invention. Details of circuit processing steps which are well known to a circuit manufacturer are not reported. One would refer to the numerous appropriate documents that are available, including instructions that are provided with the circuit processing tools by the suppliers of these tools.

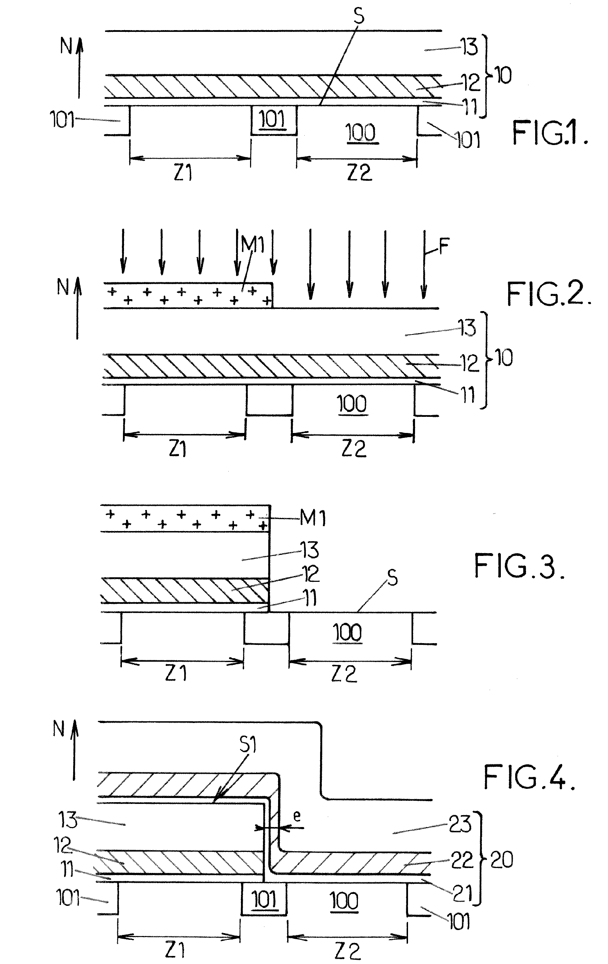

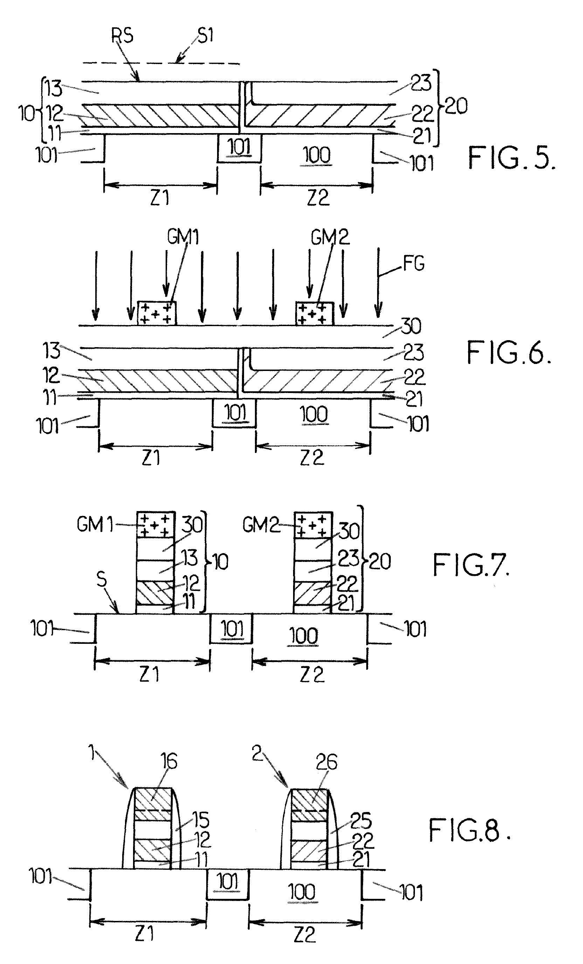

Referring to Figure 1, a substrate 100 of the integrated electronic circuit is composed of single crystalline silicon and has an upper active surface S. Surface S is substantially planar and direction N is perpendicular to surface S. Electrically insulating portions 101, for example of STI type, for "Shallow Trench Isolator", have been formed in substrate 100 below surface S in an usual manner. Insulating portions 101 form boundaries separating active zones in the surface S. Z1 and Z2 indicate first and second active zones, respectively, which are dedicated for containing field effect transistors of opposite types. For illustrative purpose, a n-MOS transistor with reference number 1 in Figure 8 is to be manufactured in active zone Z1, and a p-MOS transistor with reference number 2 is to be manufactured in active zone Z2.

In a known manner, substrate 100 is doped within the active zones Z1 and Z2, by implanting doping elements. In particular, a photolithography mask which conceals the active zone Z1 is used for implanting p-doping species selectively in the active zone Z2.

A first gate stack 10 is deposited on the substrate surface S. Stack 10 comprises, according to the deposition order, a first dielectric layer 11, a first metal-like layer 12, and a first silicon-based layer 13. Layer 11 may be composed of hafnium oxide (HfO₂) and may be 2 nm thick (nm for nanometer), for example. Layer 12 may be composed of tantalum carbide (TaC) and may be 10 nm thick. Layer 13, which is optional, may be of polysilicon (poly-Si) and 150 nm thick. Layer 13 may be n-doped initially at the time of being deposited on the circuit, or may be doped later after deposition.

In a next step, a hard mask M1 is formed on the first gate stack 10 circuit, selectively in the active zone Z1 (Figure 2). The hard mask M1 may be composed of silica (SiO₂) deposited using a Chemical Vapour Deposition (CVD) process. The hard mask M1 may be formed using the lithography mask already used for doping the substrate 100 in the active zone Z2.

Then, the first gate stack 10 is etched selectively in the active zone Z2, while it remains unchanged in the active zone Z1 due to the protection provided by the hard mask M1. For example, a dry etching process may be implemented, which consists in directing a beam F of etching species onto the upper surface of the circuit, parallel to direction N and oriented downwards. Circuit structure illustrated in Figure 3 is obtained, where surface S of the substrate 100 in exposed in the active zone Z2.

The hard mask M1 is removed, without affecting other parts of the circuit. The upper surface of the first gate stack 10 is thus uncovered in the active zone Z1, and is denoted S1.

A second gate stack 20 is then deposited on the circuit, which extends continuously over the whole upper surface of the circuit. It is deposited on the surface S1 of the first gate stack 10 in the first active zone Z1, and on the surface S of the substrate 100 in the second active zone Z2. Stack 20 comprises, according to the deposition order, a second dielectric layer 21, a second metal-like layer 22, and a second silicon-based layer 23. Layer 21 may be composed of silicon oxynitride (SiON) and may be 3 nm thick, for example. Layer 22 may be composed of molybdenum (Mo) and may be 10 nm thick, and layer 23, which is implemented in combination with layer 13, may be of polysilicon (poly-Si) and may be 150 nm thick (nm for nanometer). Layer 23 may be p-doped initially at the time of being deposited on the circuit, or may be doped later on.

According a preferred implementation of the invention, at least one of the second dielectric layer 21 and the second metal-like layer 22 is deposited by using a directional deposition process. The deposition direction is substantially perpendicular to the substrate surface S, i.e. parallel to direction N with opposite orientation. Such directional deposition process may be based on plasma-sputtering of the material to be deposited from a target of this material, for example. Using such directional deposition process reduces a total thickness e of vertical bridging parts of the layers 21 and 22 that may cover the lateral edge of the first gate stack 10 between the zones Z1 and Z2.

Then, the upper surface of the circuit is polished using a chemical-mechanical polishing (CMP) process of common use in the art. The duration of the polishing step can be controlled using various methods. According to a first one of these methods, the polishing step duration has been determined during a preliminary experiment so that the second dielectric layer 21 is removed in the first active zone Z1 after the second metal-like layer 22, and the polishing step is stopped when a removal surface RS is located within the first silicon-based layer 13 in the first active zone Z1. In Figure 5, the removal surface RS which moves downwardly during the polishing step is below surface S1 at the end of the polishing step. At this time, the upper surface of the circuit is planar again.

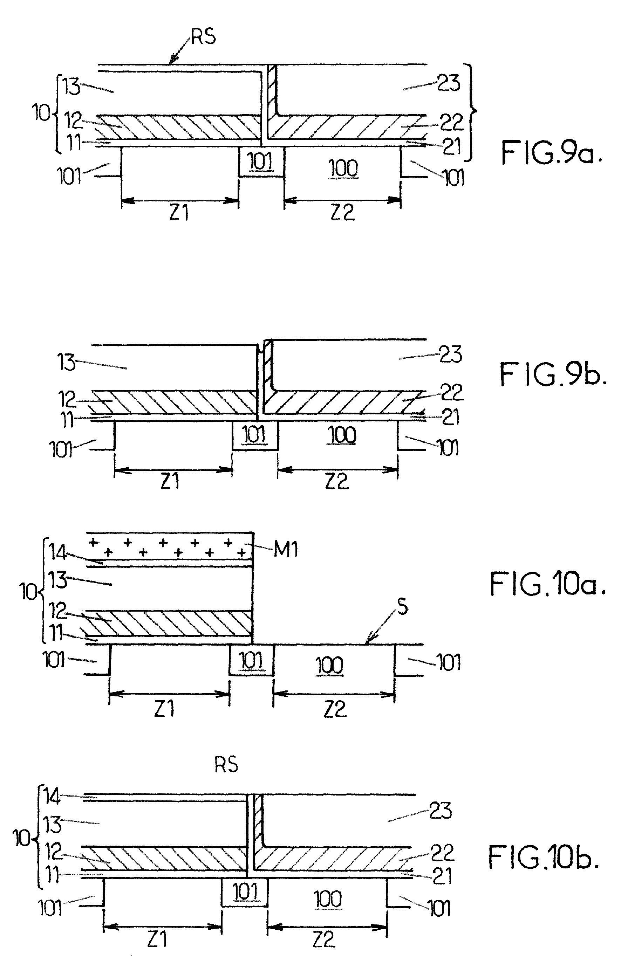

Another method for determining the end of the polishing step may consist in monitoring the materials of the gate stacks 10, 20 that are being removed. The polishing step is continued at least until the material of the second dielectric layer 21 begins to be detected. The circuit then has a structure as illustrated in Figure 9a. At this time, the removal surface RS has just reached the upper surface of the layer 21 in the first active zone Z1, so that this layer is exposed in this zone. Layer 21 is then further removed in the active zone Z1, for example by using a selective wet etching process (Figure 9b). Layer 21 may also be completely removed in the active zone Z1 by going on further with the polishing step.

According to still another method, the first gate stack 10 may further comprise a stop layer 14 deposited after the first silicon-based layer 13. The stop layer 14 may be composed of silicon nitride (S₁₃N₄), for example. It is selectively removed in the second active zone Z2 after the other layers of the first gate stack 10 using the etching beam F (Figure 10a corresponding to Figure 3 for this method). The second gate stack 20 is then deposited as explained above in connection with Figure 4. It lies on top of the stop layer 14 in the active zone Z1. Then, the chemical-mechanical polishing is used for removing the second dielectric layer 21 after the second metal-like layer 22, and it is stopped when the removal surface RS has reached the stop layer 14 in the first active zone Z1 (Figure 10b). Then, the stop layer 14 in the first active zone Z1 is removed, for example using a selective wet etching process.

Afterwards, a third silicon-based layer 30 may be advantageously deposited on the circuit, on top of the gate stacks 10 and 20 respectively in the active zones Z1 and Z2 (Figure 6). Layer 30 may be composed of undoped polysilicon. If necessary, the upper surface of layer 30 may be planarized, for example by implementing another polishing step.

Then, the process of manufacturing CMOS transistors 1 and 2 can be completed. In particular, gate masks GM1 and GM2 are formed in the first active zone Z1 and the second active zone Z2 for defining the final gate structures (Figure 6). Gate stacks 10 and 20 are etched out of the masks GM1 and GM2 using a gate etching beam FG. Actually, the thicknesses of the layers 11-13 and 21-23 may be adapted in accordance with respective etching rates of the materials of these layers, so that the gate stacks 10 and 20 are totally removed at the same time. Put another way, the thicknesses are selected so that the removal surface reaches the surface S of the substrate 100 at a same time in both active zones Z1 and Z2, out of the gate masks GM1 and GM2 (Figure 7).

Gate masks GM1 and GM2 are removed and spacers 15 and 25 are formed about the remaining parts of the gate stacks 10 and 20 for completing the transistors 1 and 2 (Figure 8). Then, a chemical element such as cobalt (Co) or nickel (Ni) may be reacted with the silicon-based material that is exposed in the active zones Z1 and Z2. Portions 16 and 26 of a silicide compound are thus formed in respective exposed upper parts of the first gate stack 10 and second gate stack 20 opposite the substrate 100. These silicide portions 16 and 26 are intended for reducing resistances of electrical contacts to be arranged respectively on the gate stacks 10 and 20. When a silicon-based layer 30 has been added on top of the layers 13 and 23, the silicide reaction is performed preferably so that boundaries of the silicide compound with the underlying silicon-based material are located within the layers 13 and 23 respectively of the gate stacks 10 and 20. In this way, the remaining silicon portion which is comprised in each gate structure does not have any additional internal interface which would possibly promote a corrosion process.

It will be apparent to the man skilled in the art that many changes can be introduced in the implementations of the invention that have been described in detail here-above, while maintaining at least several advantages of the invention. In particular, cited materials and thicknesses can be varied, depending on the circuit integration technology that is used.

## Claims

1. Process for manufacturing a first field effect transistor (1) and a second field effect transistor (2) on a substrate (100) of integrated circuit, comprising the following steps:
/1/ depositing a first gate stack (10) on a surface (S) of the substrate, in first (Z1) and second (Z2) active zones respectively of the first and second transistors, said first gate stack (10) comprising a first dielectric layer (11) and a first metal-like layer (12) deposited after said first dielectric layer;
/2/ removing said first gate stack (10) selectively in the second active zone (Z2);
/3/ depositing a second gate stack (20) above the first gate stack in the first active zone (Z1) and on the surface of the substrate (100) in the second active zone (Z2), said second gate stack comprising a second metal-like layer (22); and
/4/ removing the second gate stack (20) in the first active zone (Z1) by performing a chemical-mechanical polishing for removal of at least said second metal-like layer (22),
said process being **characterized in that** the second gate stack (20) further comprises a second dielectric layer (21) deposited before said second metal-like layer (22).

2. Process according to Claim 1, wherein each one of the first (10) and second (20) gate stacks further comprises respectively first (13) and second (23) silicon-based layers deposited after said first (12) or second (22) metal-like layer in the corresponding first gate stack or second gate stack.

3. Process according to Claim 2, wherein the chemical-mechanical polishing in step /4/ is also used for removal of the second dielectric layer (21) in the first active zone (Z1) after the removal of the second metal-like layer (22), and is stopped when a removal surface (RS) is located within the first silicon-based layer (13) of the first gate stack (10) in said first active zone (Z1).

4. Process according to Claim 2, wherein the chemical-mechanical polishing in step /4/ is continued until the second dielectric layer (21) is exposed in the first active zone (Z1), and said second dielectric layer is then further removed in said first active zone.

5. Process according to Claim 4, wherein said second dielectric layer (21) is removed in the first active zone (Z1) using a selective wet etching process.

6. Process according to Claim 2, wherein the first gate stack (10) further comprises a stop layer (14) deposited after the first silicon-based layer (13), and wherein the chemical-mechanical polishing in step /4/ is also used for removal of the second dielectric layer (21) after the removal of the second metal-like layer (22), and is stopped when a removal surface (RS) has reached the stop layer (14) in the first active zone (Z1), and the stop layer in the first active zone is then removed.

7. Process according to any one of claims Claim 2 to 6, further comprising the following step performed after step /4/:
/5/ depositing a third silicon-based layer (30) on the first (10) and second (20) gate stacks.

8. Process according to Claim 7, further comprising the following step:
/6/ reacting a chemical element with silicon-based material exposed in the first (Z1) and second (Z2) active zones so as to form portions of a silicide compound in respective exposed parts of the first gate stack (10) and second gate stack (20) opposite the substrate (100),
wherein step /6/ is performed so that boundaries of the silicide compound with silicon-based material are located within the first (13) and second (23) silicon-based layers respectively of the first (10) and second (20) gate stacks.

9. Process according to any one of the preceding claims, wherein step /2/ is performed using a same lithography mask as used for doping the substrate (100) in the second active zone (Z2).

10. Process according to any one of the preceding claims, wherein at least one of the second dielectric layer (21) and the second metal-like layer (22) is deposited in step /3/ using a directional deposition process, with a deposition direction substantially perpendicular to the substrate surface (S).

11. Process according to anyone of the preceding claims, wherein said first (11) and second (12) dielectric layers are composed of different respective dielectric materials.

12. Process according to any one of the preceding claims, wherein at least one of the first (11) and second (21) dielectric layers comprises a dielectric material with permittivity higher than 10, preferably higher than 25.

13. Process according to any one of claims 1 to 12, wherein said first (1) and second (2) transistors are of opposite types selected from p-MOS and n-MOS types.

14. Process according to claim 13, wherein said first (12) and second (22) metal-like layers are composed of different respective materials.

15. Process according to any one of claims 1 to 12, wherein said first (1) and second (2) transistors are adapted for different respective operations selected from analog operation and digital operation.
